# EUROPEAN PATENT APPLICATION

(11) **EP 3 115 100 A1**
(43) Date of publication of application: **11.01.2017**
(21) Application number: 15759092.8
(22) Date of filing: 06.03.2015
(51) Int. Cl.: B01D 63/08, B01D 69/12, B01D 71/36, H01G 9/12, H01G 11/14, H01G 11/84, H01M 2/12, H05K 5/06, H01M 2/04

(54) **LID FOR AIR-PERMEABLE CONTAINER, AIR-PERMEABLE CONTAINER, AND PRODUCTION METHOD FOR LID FOR AIR-PERMEABLE CONTAINER**

(30) Priority: 06.03.2014 JP 2014044296
(71) Applicant: Nitto Denko Corporation, Ibaraki-shi, Osaka 567-8680 (JP)
(72) Inventor: ISHII, Kyouko, Ibaraki-shi Osaka 567-8680 (JP); FURUUCHI, Kouji, Ibaraki-shi Osaka 567-8680 (JP); YANO, Yozou, Ibaraki-shi Osaka 567-8680 (JP); FUKUOKA, Takahiro, Ibaraki-shi Osaka 567-8680 (JP); KIRA, Yoshiko, Ibaraki-shi Osaka 567-8680 (JP)
(74) Representative: Müller-Boré & Partner Patentanwälte PartG mbB
(86) International application number: PCT/JP2015/056719
(87) International publication number: WO 2015/133623

(57) **Abstract**

A cover for gas permeable container which is mounted on a container body having an internal space and an opening communicating with the internal space includes: a closing part configured to close the opening; and a gas permeable part configured to be permeable to a gas, thereby allowing the gas to flow between the internal space and an outer space of the container body, wherein the gas permeable part is constituted by a gas permeable member having a gas permeable sheet, and the gas permeable member is integrally formed with a material constituting the closing part.

## Description

### CROSS-REFERENCE TO RELATED APPLICATION

This application claims priority to Japanese Patent Application No. 2014-44296, the disclosure of which is incorporated herein by reference in its entirety.

### FIELD

The present invention relates to a cover for gas permeable container including a gas permeable part, a gas permeable container including the cover, and a method for producing the cover for gas permeable container.

### BACKGROUND

When gases are generated within a sealed container, the atmospheric pressure within the container increases, which may possibly result in damage or explosion of the container. For example, in electric storage devices such as secondary batteries, electrolytic capacitors, and electric double layer capacitors, a specific gas is generated during use within a container in which an electrode is housed, and therefore such a gas may possibly cause damage or explosion of the container if the gas is not discharged to the outside of the container. Therefore, various structures to discharge the gas inside the container to the outside of the container have been proposed.

For example, as a container constituting an electric storage device, a container configured to house an electrode and an electrolyte, the container including a gas permeable part through which gases permeate, thereby enabling circulation of the gases from inside to outside via the gas permeable part (hereinafter, referred to as a gas permeable container) has been proposed.

In such a gas permeable container, the gas permeable part is formed by mounting a gas permeable sheet through which gases permeate on a through hole formed in a container body housing the electrode and the electrolyte so as to cover the through hole. Thus, the gases generated inside the gas permeable container are configured to permeate through the gas permeable part (specifically, the gas permeable sheet), so as to be discharged to the outside of the gas permeable container (see Patent Literatures 1 and 2).

The gas permeable sheet as described above is an exceptionally thin sheet and is very easily damaged. Further, if an impurity or the like is deposited on the surface of the gas permeable sheet, the gas permeability decreases. Therefore, the gas permeable sheet needs to be handled so as not to be contaminated. Accordingly, it is a very complicated operation to cut the gas permeable sheet into a size corresponding to the size of the opening of the through hole or to arrange it on the edge of the opening of the through hole while preventing damage and contamination.

Therefore, there is a gas permeable container in which, on a through hole of such a container body as described above, a gas permeable member with a gas permeable sheet mounted on a holder is mounted.

Examples of such a gas permeable member include a gas permeable member in which a gas flow hole through which gases are circulated is formed in a holder, and a gas permeable sheet is held to intersect the gas flow hole. The gas permeable member is inserted into the through hole of the container body to be mounted thereon, so that gases generated inside the gas permeable container are configured to be discharged to the outside of the container by permeating through the gas permeable sheet via the gas flow hole.

Such a gas permeable member is mounted on the through hole of the cover by being inserted thereinto, and therefore the operation of mounting the gas permeable sheet on the container body can be easily carried out.

Meanwhile, the through hole generally needs only to allow gas permeation to an extent such that the pressure inside the gas permeable container does not cause damage or explosion of the container, and thus is set to have the minimum required size. Accordingly, there is a problem that, for example, in the case where the atmospheric pressure inside the container rapidly increases for any reason, high pressure is applied around the through hole to separate the gas permeable member from the through hole, so that the gas permeable part is easily damaged.

In order to increase the strength of the gas permeable part by firmly mounting the gas permeable member on the through hole, it is conceivable to mount the gas permeable member on the through hole using an adhesive or the like, but adhesion with high strength is difficult. Further, in the case of mounting the gas permeable member on the container body using an adhesive or the like, a step of applying the adhesive onto the inner circumferential surface of the through hole or the outer circumferential surface of the holder is required, and thus the production operation becomes complicated.

### CITATION LIST

### Patent Literature

Patent Literature 1: WO 2009/1947 A
Patent Literature 2: Japanese Patent No. 4280014

### SUMMARY

### Technical Problem

It is therefore an object of the present invention to easily provide a cover for gas permeable container and a gas permeable container that include a gas permeable part with comparatively high strength.

It is another object of the present invention to provide a method for producing a cover for gas permeable container by which a cover for gas permeable container including a gas permeable part with comparatively high strength can be easily produced.

### Solution to Problem

A cover for gas permeable container according to the present invention which is mounted on a container body having an internal space and an opening communicating with the internal space, the cover for gas permeable container including: a closing part configured to close the opening; and a gas permeable part configured to be permeable to a gas, thereby allowing the gas to flow between the internal space and an outer space of the container body, wherein the gas permeable part is constituted by a gas permeable member having a gas permeable sheet, and the gas permeable member is integrally formed with a material constituting the closing part.

In the present invention, the gas permeable member may include a holder configured to hold the gas permeable sheet.

In the present invention, a protective member arranged on at least one of the internal space side and the outside of the gas permeable sheet may be provided.

A gas permeable container according to the present invention includes the cover for gas permeable container.

A method for producing a cover according to the present invention includes, while arranging the gas permeable member constituting the cover for gas permeable container within a mold, injecting the material constituting the closing part into the mold to form the closing part within the mold, so as to produce the cover for gas permeable container in which the gas permeable member is integrally formed with the closing part.

### BRIEF DESCRIPTION OF DRAWINGS

Fig. 1 is a partial sectional perspective view showing a gas permeable container of an embodiment.
Fig. 2 is an enlarged sectional perspective view of A-part shown in Fig. 1.
Fig. 3A is a sectional view showing a cover for gas permeable container of another embodiment.
Fig. 3B is a sectional view showing a cover for gas permeable container of another embodiment.
Fig. 3C is a partial sectional perspective view showing a protective member of a cover for gas permeable container of another embodiment.
Fig. 4A is a sectional view showing a gas permeable part of another embodiment.
Fig. 4B is a sectional view showing a cover for gas permeable container of another embodiment.
Fig. 5A is a schematic perspective view describing a production method of an embodiment.
Fig. 5B is a partial sectional perspective view describing a production method of an embodiment.

### DESCRIPTION OF EMBODIMENTS

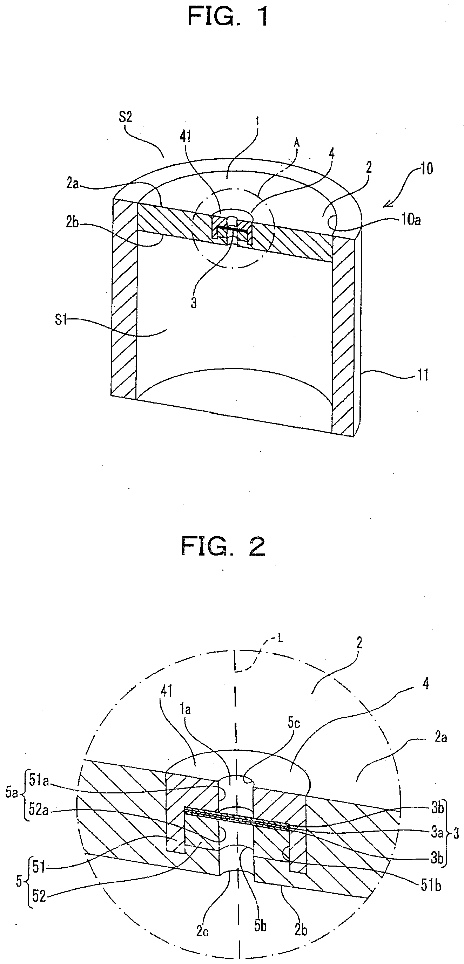

Hereinafter, an embodiment of the present invention will be described with reference to Figs. 1 to 5. In the following drawings, the same or corresponding portions are denoted by the same reference numerals, and the description thereof is not repeated.

### First embodiment

As shown in Fig. 1 and Fig. 2, a cover for gas permeable container 1 according to this embodiment which is mounted on a container body 11 having an internal space S1 and an opening communicating with the internal space S1 includes a closing part 2 configured to close the opening and a gas permeable part 4 configured to be permeable to a gas, thereby allowing the gas to flow between the internal space S1 and an outer space S2 of the container body 11, wherein the gas permeable part 4 is constituted by a gas permeable member 41 having a gas permeable sheet 3, and the gas permeable member is integrally formed with a material constituting the closing part 2.

Specifically, the cover for gas permeable container 1 of this embodiment includes the closing part 2, and the gas permeable part 4 constituted by the gas permeable member 41 having the gas permeable sheet 3 through which a gas permeates.

The closing part 2 includes the gas permeable part 4 which is configured to close an opening 10a so as to be permeable to a gas, thereby allowing the gas to flow between the internal space S1 and the outer space S2 of the container body 10, when the cover for gas permeable container 1 is mounted on the container body 11 having the opening 10a, as shown in Fig. 1.

The closing part 2 is formed into a shape such that the closing part 2 can be fitted to the opening 10a of the container body 10 on which it is mounted. For example, in this embodiment, the closing part 2 is formed into a circular plate body in top view, corresponding to the circular opening 10a.

The material constituting the closing part 2 is not specifically limited as long as it is a forming material that can be integrally formed with the gas permeable member 41 constituting the gas permeable part 4, which will be described later. Examples thereof include thermosetting resins such as phenol resin, and thermoplastic resins such as PBT (Poly Butylene Terephtalate) resin.

In particular, phenol resin is preferable in view of heat resistance, moisture resistance, and chemical resistance.

In this embodiment, the gas permeable part 4 is provided at one place in the center in top view of the closing part 2.

The gas permeable part 4 of this embodiment is constituted by the gas permeable member 41 having the gas permeable sheet 3 and a holder 5 configured to hold the gas permeable sheet 3.

The gas permeable part 4 includes a gas permeable path 1a which is permeable to a gas, thereby allowing the gas to flow between the internal space S1 and the outer space S2 of the container body 11.

As the gas permeable sheet 3, a selective permeable sheet 3a that allows a specific gas to selectively permeate therethrough or a non-selective permeable sheet 3b without such selectivity for a specific gas is used. In this embodiment, the gas permeable sheet 3 including a plurality of pieces (specifically, 3 pieces) is used, where one is a selective permeable sheet 3a, and the other two are non-selective permeable sheets 3b.

The selective permeable sheet 3a is configured to be selectively permeable to a specific gas, thereby allowing the specific gas to flow from one surface side to the other surface side. The gas to which the selective permeable sheet 3a is permeable is not specifically limited, and examples thereof include gases such as hydrogen, carbon dioxide, and oxygen.

As the selective permeable sheet 3a having selectivity for hydrogen gas, the selective permeable sheet 3a constituted by a sheet material containing a resin such as aromatic polyimide or a sheet material containing a layer of hydrogen-permeable metal (such as vanadium, vanadium alloy, palladium alloy, niobium, and niobium alloy) can be mentioned, for example. Examples of the sheet material containing a hydrogen-permeable metal layer include a sheet material (metal foil) composed only of a hydrogen-permeable metal layer, and a sheet material formed by vapor deposition of a metal layer on a substrate layer such as a resin sheet. As the selective permeable sheet 3a that allows carbon dioxide to selectively permeate therethrough, the selective permeable sheet 3a constituted by a sheet material made of silicone rubber, a PVA (polyvinyl alcohol) crosslinked sheet material, a PEG (polyethylene glycol) crosslinked sheet material, or the like, can be mentioned.

A non-selective permeable sheet 3b is arranged on at least one surface side (each of both sides in this embodiment) of the selective permeable sheet 3a so as to overlap the selective permeable sheet 3a. The non-selective permeable sheet 3b can be appropriately selected depending on the properties, etc., of the selective permeable sheet 3a to be laminated therewith, but examples thereof include the non-selective permeable sheet 3b constituted by a sheet material such as a porous film made of polytetrafluoroethylene (PTFE), ceramic, metal, resin, or the like. In particular, a porous film made of PTFE is preferable as a sheet material constituting the non-selective permeable sheets 3b because of its high water repellency, high heat resistance, and high chemical resistance.

In this embodiment, the holder 5 is formed into a cylindrical shape (specifically, cylindrical shape about the axis L), and a hole 5a is formed at the center. Both ends of the hole 5a are configured to be open at both ends of the holder 5.

In this embodiment, the holder 5 is configured to allow a gas flowing therein from an opening (hereinafter, referred to also as an inlet port) 5b formed on one end side of the hole 5a to be discharged through an opening (hereinafter, referred to also as outlet port) 5c formed on the other end side.

That is, the holder 5 includes the hole 5a that serves as a flow path to circulate the gas from the inlet port 5b side to the outlet port 5c side in a direction along the axis L.

Here, the axis L is an imaginary line passing through the centers of the openings 5b and 5c of the holder 5.

The holder 5 of this embodiment is constituted by a plurality of members (two in this embodiment). That is, the holder 5 includes a first member 51 and a second member 52 that are separable in the direction of the axis L.

The first member 51 is a cylindrical member that constitutes a part on the outlet port 5c side of the holder 5 and has a hole 51a at the center and a recess 51b formed on an end side opposite to the outlet port 5c.

The second member 52 is a cylindrical member that can be fitted to the recess 51b and has a hole 52a at the center.

The gas permeable sheet 3 (specifically, a laminated sheet of the selective permeable sheet 3a and the non-selective permeable sheets 3b) is arranged within the recess 51b of the first member 51, and the second member 52 is fitted to the recess 51b so as to fix the gas permeable sheet 3 between the first member 51 and the second member 52.

The first member 51 and the second member 52 are configured to have the centers of their holes coinciding with each other when they are mounted. That is, the hole 5a of the holder 5 is constituted by the hole 51a of the first member 51 and the hole 52a of the second member 52.

The gas permeable part 4 and the closing part 2 of this embodiment are formed by the gas permeable member 41 being integrally formed with the material constituting the closing part 2.

Here, "being integrally formed" means to put the material constituting the closing part and the gas permeable member into a mold and integrate the gas permeable member with the closing part, when forming the closing part within the mold.

In this embodiment, the hole 5a of the holder constitutes a part of the gas permeable path 1a of the gas permeable part 4.

The gas permeable member 41 is arranged so that the outlet port 5c of the holder 5 is open on one surface side 2a of the closing part 2 (surface side that is arranged outside the container body 11 when mounted on the container body 11, which will be described below), and a surface at one end of the holder 5 is flush with the one surface side 2a of the closing part 2.

Meanwhile, a hole 2c that is open at the center is formed on the other surface side 2b of the closing part 2 (surface side arranged inside the container body when mounted on the container body 11, which will be described below), and the hole 2c is configured to communicate with the inlet port 5b of the holder 5.

That is, the gas permeable path 1a of the cover for gas permeable container 1 of this embodiment is constituted by the hole 2c of the closing part 2, the gas permeable sheet 3, and the hole 5a of the holder 5.

The material for the holder 5 is not specifically limited as long as it is a material capable of being integrally formed with the closing part 2, but examples thereof include resins such as PBT resin, and metals such as aluminum and stainless steel.

Next, a gas permeable container 10 using the cover for gas permeable container 1 of this embodiment as described above (hereinafter, simply referred to also as a cover) will be described.

As shown in Fig. 1, in the gas permeable container 10 of this embodiment, the cover for gas permeable container 1 of this embodiment as described above is mounted on the container body 11 having the internal space S1 in which other members are housed.

The cover for gas permeable container 1 covers the opening 10a of the container body 11 by the circumferential edge of the closing part 2 being mounted on the circumferential edge of the opening 10a of the container body 11 by welding, adhesion, or the like.

The gas permeable container 10 can discharge a gas generated in the gas permeable container 10 (specifically, the container body 11) to the outside by the gas permeable part 4 of the cover 1 through the gas permeable path 1a of the gas permeable part 4. Specifically, the generation of the gas within the container body 11 causes an increase in internal pressure of the container body 11. Following this, the gas inside the container body 11 flows into the gas permeable path 1a of the cover 1 through the opening of the hole 2c of the closing part 2. Then, the gas that has flowed into the gas permeable path 1a permeates through the gas permeable sheet 3 when it circulates within the gas permeable path 1a toward the outlet port 5c side. Then, the gas that has permeated through the gas permeable sheet 3 is discharged to the outside of the gas permeable container 10 through the outlet port 5c of the gas permeable path 1a. This reduces the internal pressure of the container body 11.

The gas permeable container 10 as described above may be used for housing an electrode or the like, for example, as a member constituting an electric storage device such as a secondary battery, an electrolytic capacitor (aluminum electrolytic capacitor, etc.), and an electric double layer capacitor, in some cases. In such a case, various gases are generated inside the gas permeable container 10. For example, in the case where the gas permeable container 10 is used as a container constituting an aluminum electrolytic capacitor, hydrogen gas is generated. In the case where it is used as a container constituting an electric double layer capacitor, carbon dioxide gas is generated. Therefore, only a specific gas can be discharged to the outside of the gas permeable container 10 by selecting the material constituting the selective permeable sheet 3a corresponding to the type of gas generated within the gas permeable container 10.

In the cover for gas permeable container 1 and the gas permeable container 10 of this embodiment configured as above, the gas permeable member 41 and the constituent material of the closing part 2 are integrally formed to form the cover for gas permeable container 1. Therefore, even if the internal pressure of the container body 11 rapidly increases, the gas permeable part 4 is less likely to be damaged, for example, due to the gas permeable sheet 3 or the gas permeable member 41 being separated from the gas permeable container.

In this embodiment, the holder 5 of the gas permeable member 41 is constituted by the first member 51 and the second member 52 that are a plurality of members, but there is no limitation to this. For example, it may be a holder constituted by one member. In this case, the method for mounting the gas permeable sheet and the holder is not specifically limited, but the gas permeable sheet and the holder may be mounted on each other by being integrally formed, or the gas permeable sheet may be mounted on the holder after the holder is formed, for example.

### Second embodiment

In the cover for gas permeable container 1 of this embodiment, the gas permeable member 41 is constituted by the gas permeable sheet 3.

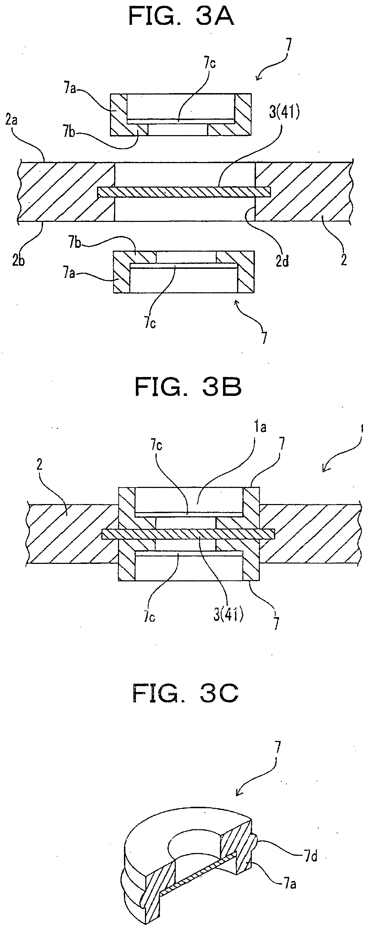

Specifically, as shown in Fig. 3, the gas permeable sheet 3 is arranged inside a hole 2d that is formed at the center of the closing part 2 and is open on both surface sides 2a and 2b of the closing part 2, so as to close the hole 2d.

More specifically, the closing part 2 and the gas permeable member 41 are integrally formed with each other so that the circumferential edge of the gas permeable sheet 3 is embedded in the inner circumferential surface of the hole 2d.

The gas permeable sheet 3 of this embodiment is a selective permeable sheet.

In the cover for gas permeable container 1 of this embodiment, the gas permeable path 1a of the gas permeable part is constituted by the hole 2d and the gas permeable sheet 3.

The cover for gas permeable container 1 of this embodiment may further include a protective member 7.

As shown in Fig. 3, the protective member 7 includes a cylindrical sidewall 7a with both ends open, a sheet mounting part 7b extending from the circumferential edge of the opening at one end of the sidewall 7a toward the center of the opening, and a circular gas permeable sheet 7c having a circumferential edge mounted on the sheet mounting part 7b inside the sidewall 7a.

The gas permeable sheet 7c may be the aforementioned selective permeable sheet or non-selective permeable sheet, but is preferably a porous film made of PTFE as described above, for example, since it is easy to protect the gas permeable sheet 3 that is integrally formed with the closing part 2 from dirt or the like in such a case.

The protective member 7 is inserted into the hole 2d communicating with at least one (both in this embodiment) of the openings on both surface sides 2a and 2b of the closing part 2 through the opening from the sheet mounting part 7b side so as to be mounted on the closing part 2.

That is, the protective member 7 is mounted on the cover 1 so that the gas permeable sheet 7c of the protective member 7 is arranged outside the gas permeable sheet 3 integrally formed with the closing part 2.

Also in the gas permeable container using the cover for gas permeable container 1 of this embodiment, the cover for gas permeable container 1 is mounted on the container body to constitute the gas permeable container, in the same manner as in the first embodiment.

The gas permeable container of this embodiment is configured so that the gas permeable sheet 7c of the protective member 7 is arranged on each of both surface sides of the gas permeable sheet 3 integrally formed with the closing part 2, that is, the internal space side and the outer space side of the container body 11. Accordingly, contents housed in the internal space of the container body and contaminants such as dirt from the outer space, for example, are prevented from depositing on the gas permeable sheet 3 integrally formed with the closing part 2, by the gas permeable sheet 7c of the protective member 7.

The shape of the protective member 7 of this embodiment is not specifically limited. For example, as shown in Fig. 3C, the protective member 7 having an annular projection 7d that is formed on the outer circumferential surface of the sidewall 7a may be employed.

The protective member 7 can be inserted into the hole 2d of the closing part 2 in the state where the protective member 7 and the hole 2d are sealed together by the projection 7d abutting the inner wall of the hole 2d when the protective member 7 is inserted into the hole 2d of the closing part 2 from the sheet mounting part 7b side.

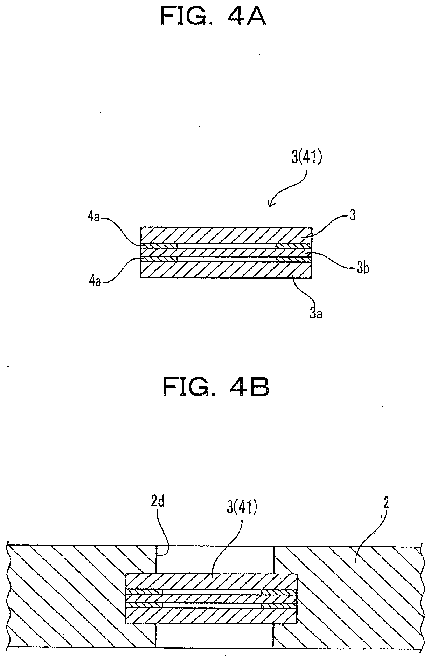

A modification of the second embodiment will be described with reference to Fig. 4.

In the cover for gas permeable container 1 of this modification, the gas permeable part 4 is constituted by the gas permeable member 41 composed of the gas permeable sheet 3.

In this modification, as the gas permeable sheet 3, a laminated permeable sheet in which the non-selective permeable sheets 3b are laminated on both surface sides of the selective permeable sheet 3a is used.

The laminated permeable sheet of this modification is constituted by forming an adhesive part 4a on the circumferential edge of the selective permeable sheet 3a and laminating the non-selective permeable sheets 3b via the adhesive part 4a.

The adhesive part can be formed by arranging an adhesive, an adhesion tape, an adhesive resin sheet, or the like, on the circumferential edge of the selective permeable sheet 3a.

As a material for the non-selective permeable sheets 3b, a porous film or the like made of PTFE is preferable, for example, as in the gas permeable sheet 7c mounted on the protective member 7, since it is easy to protect the selective permeable sheet 3a from dirt or the like.

The gas permeable member 41 of this modification is constituted by the laminated permeable sheet in which the non-selective permeable sheets 3b are laminated on both surface sides of the selective permeable sheet 3a in advance, and therefore can prevent contamination of the selective permeable sheet 3a without using the protective member as in the second embodiment.

### Third embodiment

Next, a third embodiment relating to a method for producing a cover for gas permeable container will be described.

The method for producing a cover for gas permeable container of this embodiment includes, while arranging the gas permeable member constituting the cover for gas permeable container within a mold, injecting a material constituting a closing part into the mold to form it within the mold, so as to produce the cover for gas permeable container in which the gas permeable member is integrally formed with the closing part.

More specifically, a method for producing the cover for gas permeable container of the second embodiment will be described, in this embodiment.

First, a gas permeable sheet serving as the gas permeable member 41 of the cover for gas permeable container 1 of the second embodiment is fed into the mold.

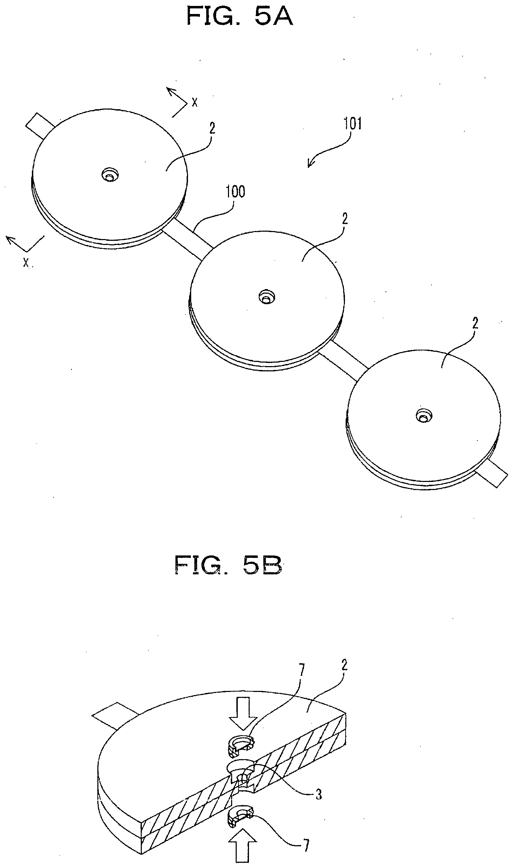

At this time, the gas permeable sheet is fed into the mold as an elongated gas permeable sheet continuous body 100, as shown in Fig. 5.

The gas permeable sheet continuous body 100 is arranged within the mold so that a space is formed on each of both surface sides of a specific point. That is, the gas permeable sheet continuous body 100 allows the gas permeable sheet to be arranged so that the material constituting the closing part is injected into the mold so as to sandwich the gas permeable sheet continuous body 100.

The mold has an internal space in which the closing part of the second embodiment can be formed. That is, the internal space has a shape such that a circular plate body is formed, and the mold includes a core that can form a hole exposing the gas permeable sheet on both surface sides at the center of the portion to serve as the closing part.

The closing part 2 is integrally formed at a specific place in the elongated gas permeable sheet continuous body 100 by injecting a forming material that is the material constituting the closing part into the mold, followed by curing.

Further, another place at a specific interval from the one place of the gas permeable sheet continuous body 100 is arranged within the mold in the same manner, so as to integrally form the closing part 2. Thus, a cover continuous body 101 in which the closing part 2 is integrally formed at a plurality of places is formed.

Thereafter, the gas permeable sheet continuous body 100 is cut at the places where the closing part 2 is not formed, and the gas permeable sheet protruding from the closing part 2 is then cut off.

Thereafter, as shown in Fig. 5B, the protective member 7 as described above in the second embodiment is inserted into the hole at the center of the closing part 2, thereby producing the cover of the second embodiment.

According to the method for producing a cover of this embodiment, a plurality of covers can be easily produced.

### Fourth embodiment

In this embodiment, a method for producing a cover for gas permeable container of the first embodiment will be described.

In the production method of this embodiment, the gas permeable member of the first embodiment is arranged within the mold.

In this embodiment, the gas permeable member is arranged within the mold so that the gas permeable member 41 and the closing part 2 are arranged as shown in Fig. 2 after forming.

Specifically, the gas permeable member 41 is arranged within the mold at a position such that the end on one side of the gas permeable member 41 is flush with the surface on one surface side of the closing part, and the end on the other side is embedded at a specific depth from the surface on the other surface side of the closing part 2 (at a depth of the hole 2c in Fig. 2). The mold includes a core at a position such that a hole that corresponds to the hole 2c can be formed in a portion of a formed product that serves as the closing part 2.

After the gas permeable member 41 is arranged within the mold as described above, the material constituting the closing part (forming material) is injected into the mold, in the same manner as in the third embodiment, followed by curing the forming material, thereby producing a cover.

According to the method for producing a cover of this embodiment, the gas permeable member 41 including the holder is integrally formed with the material of the closing part 2, and therefore it is easier to prevent damage of the gas permeable sheet and to produce a cover than in the case where the gas permeable sheet is integrally formed directly with the closing part.

The cover for gas permeable container, the gas permeable container, and the method for producing a cover for gas permeable container according to the present invention are not limited to the aforementioned embodiments, and various modifications can be made without departing from the gist of the present invention. Further, the configurations, methods, and the like, of the aforementioned plurality of embodiments may be optionally employed and combined (the configuration, method, and the like, according to an embodiment may be applied to the configuration, method, and the like, according to another embodiment). Further, it is a matter of course that the configurations, methods, and the like, of various modifications described below may be optionally selected to be used for the configurations, methods, and the like, of the aforementioned embodiments.

For example, in the aforementioned embodiments, the selective permeable sheet 3a and the non-selective permeable sheets 3b are used as the gas permeable sheet 3, but there is no limitation to this. For example, one or a plurality of only either the selective permeable sheet 3a or the non-selective permeable sheet 3b may be used as the gas permeable sheet 3.

Further, in the aforementioned embodiments, the cover for gas permeable container includes the gas permeable part at one place in the closing part, but the gas permeable part may be provided at a plurality of places in the closing part.

In this case, it is preferable, in the production of the cover, that a plurality of gas permeable members are housed within the mold and are integrally formed with the material constituting the closing part, so as to produce the cover.

According to the present invention as described above, a cover for gas permeable container including the gas permeable part having a comparatively high strength can be easily obtained by providing a cover for gas permeable container which is mounted on a container body having an internal space and an opening communicating with the internal space, the cover including: a closing part configured to close the opening; and a gas permeable part configured to be permeable to a gas, thereby allowing the gas to flow between the internal space and an outer space of the container body, wherein the gas permeable part is constituted by a gas permeable member having a gas permeable sheet, and the gas permeable member is integrally formed with a material constituting the closing part.

Further, in the present invention, in the case where the gas permeable member has a holder configured to hold the gas permeable sheet, a cover for gas permeable container including the gas permeable part with higher strength can be easily obtained.

Further, in the present invention, in the case where a protective member that is arranged on at least one surface side of the gas permeable sheet is further provided, it is easier to obtain a cover for gas permeable container including a gas permeable part with high strength, and it is possible to protect the gas permeable sheet from contamination or damage, at the same time.

That is, according to the present invention, a cover for gas permeable container and a gas permeable container that include a gas permeable part with comparatively high strength can be easily provided.

Further, a method for producing a cover for gas permeable container that enables a cover for gas permeable container including a gas permeable part with comparatively high strength to be easily produced can be provided.

### REFERENCE SIGNS LIST

- 1:: Cover for gas permeable container (cover)
- 2:: Closing part
- 3:: Gas permeable sheet
- 4:: Gas permeable part
- 41:: Gas permeable member
- 5:: Holder
- 10:: Gas permeable container
- 11:: Container body

## Claims

1. A cover for gas permeable container which is mounted on a container body having an internal space and an opening communicating with the internal space, the cover for gas permeable container comprising:
a closing part configured to close the opening; and
a gas permeable part configured to be permeable to a gas, thereby allowing the gas to flow between the internal space and an outer space of the container body, wherein
the gas permeable part is constituted by a gas permeable member having a gas permeable sheet, and
the gas permeable member is integrally formed with a material constituting the closing part.

2. The cover for gas permeable container according to claim 1, wherein
the gas permeable member comprises a holder configured to hold the gas permeable sheet.

3. The cover for gas permeable container according to claim 1 or 2, further comprising:
a protective member arranged on at least one surface side of the gas permeable sheet.

4. A gas permeable container comprising:
the cover for gas permeable container according to any one of claims 1 to 3.

5. A method for producing a cover for gas permeable container, comprising:
while arranging the gas permeable member constituting the cover for gas permeable container according to any one of claims 1 to 3 within a mold, injecting the material constituting the closing part into the mold to form the closing part within the mold, so as to produce the cover for gas permeable container in which the gas permeable member is integrally formed with the closing part.
